# EUROPÄISCHE PATENTSCHRIFT

(11) **EP 1 959 302 B1**
(45) Veröffentlichungstag und Bekanntmachung des Hinweises auf die Patenterteilung: **03.04.2013**
(21) Anmeldenummer: 08002449.0
(22) Anmeldetag: 11.02.2008
(51) Int. Cl.: G03F 7/20, B29D 11/00, G02B 27/42

(54) **Verfahren zur Herstellung eines diffraktiven optischen Elements sowie nach einem derartigen Verfahren hergestelltes diffraktives optisches Element**
Method for manufacturing a diffractive optical element and diffractive optical element manufactured according to a method of this type
Procédé de fabrication d'un élément optique diffractif et élément optique diffractif fabriqué selon un tel procédé

(30) Priorität: 14.02.2007 DE 102007007907; 14.02.2007 US 889787 P
(43) Veröffentlichungstag der Anmeldung: 20.08.2008
(73) Patentinhaber: Carl Zeiss SMT GmbH, 73447 Oberkochen (DE)
(72) Erfinder: Volkenandt, Harald, 73442 Aalen (DE); Weiß, Gundula, 73434 Aalen (DE)
(74) Vertreter: Hofmann, Matthias

(56) Entgegenhaltungen:
- DE-A1- 10 220 045
- US-A1- 2005 146 704
- US-A1- 2006 028 957
- US-A1- 2006 158 624

## Beschreibung

Die Erfindung betrifft ein Verfahren zur Herstellung eines diffraktiven optischen Elements. Ferner betrifft die Erfindung ein mit einem solchen Verfahren hergestelltes diffraktives optisches Element und eine Beleuchtungsoptik, die mindestens ein derartiges diffraktives optisches Element einsetzt. Weiterhin betrifft die Erfindung eine Mikrolithografie-Projektionsbelichtungsanlage mit einer derartigen Beleuchtungsoptik sowie ein Verfahren zum Herstellen eines mikroelektronischen Bauelements unter Einsatz einer derartigen Projektionsbelichtungsanlage.

Aus der US 2004/0257553 A1 sind diffraktive optische Elemente beim Einsatz in einem Projektionsobjektiv für die Mikrolithographie bekannt. Die US 6 310 679 B 1 zeigt eine Komponente zur Polarisationssteuerung innerhalb einer Projektionsoptik einer Projektionsbelichtungsanlage. Die DE 102 60 819 A1 zeigt verschiedene Ätzverfahren zur Herstellung diffraktiver optischer Elemente. Die DE 103 21 598 A1 beschreibt die Verwendung von doppelbrechenden Elementen mit über deren optischer Fläche verteilten Abschnitten unterschiedlicher doppelbrechender Wirkung. Aus der US 6 236 439 B 1 und der DE 30 35 025 A 1 sind optische Komponenten mit doppelbrechenden Schichten bekannt. Die US 2006/0158624 A1 zeigt ein Verfahren zur Herstellung eines diffraktiven optischen Elements. Die US 2005/0146704 A 1 offenbart ein Polarisationselement mit einer diffraktiven Struktur. Die US 2006/0028957 A1 offenbart eine Strahlformungskomponente mit Polarisationsstrukturen. Die DE 102 20 045 A1 beschreibt ein Verfahren zur Herstellung eines optischen Elementes aus Quarzsubstrat.

Weitere Beispiele für diffraktive optische Elemente zeigt die EP 0 921 418 B1. Diffraktive optische Elemente werden innerhalb einer Mikrolithografie-Projektionsbelichtungsanlage insbesondere zur Vorgabe eines Beleuchtungssettings, also einer bestimmten Beleuchtungswinkelverteilung zur Ausleuchtung des Retikels, genutzt. Für anspruchsvolle Beleuchtungsanforderungen wird zunehmend gewünscht, über das Beleuchtungsfeld auf dem Retikel nicht nur die Verteilung der Beleuchtungswinkel, sondern auch die Verteilung des Polarisationszustandes des Beleuchtungslichtes exakt vorzugeben. Hierzu sind diffraktive optische Elemente mit Raster- bzw. Einzelelementen in Erprobung, die aus unterschiedlichen Einzelelement-Typen mit jeweils unterschiedlicher bündelformender und polarisierender Wirkung zusammengesetzt sind.

Es ist daher eine Aufgabe der vorliegenden Erfindung, ein Herstellungsverfahren für ein diffraktives optisches Element anzugeben, bei dem mindestens zwei verschiedene Typen von Einzelelementen mit unterschiedlicher vorgegebener bündelformender und polarisierender Wirkung mit hoher Strukturgenauigkeit erzeugt werden können.

Diese Aufgabe ist erfindungsgemäß gelöst durch ein Verfahren mit den im Anspruch 1 angegebenen Verfahrensschritten.

Beim erfindungsgemäßen Herstellungsverfahren wird zunächst mindestens ein Substrat aus einem optisch polarisationsaktiven Material bereitgestellt. Ein Beispiel für ein optisch polarisationsaktives Material ist ein optisch doppelbrechendes Material. Beispiele für doppelbrechende Materialien sind beispielsweise kristallines Quarz, Magnesiumfluorid oder Saphir. Unter polarisationsaktiven Materialien werden auch optisch aktive Materialien verstanden. Dabei können doppelbrechende kristalline Materialien auch optisch aktiv sein, wie dies z.B. von kristallinem Quarz bekannt ist. Ob die polarisationsbeeinflussende Wirkung des verwendeten Materials im Wesentlichen durch optische Aktivität oder durch Doppelbrechung erfolgt, hängt beispielsweise von der Ausrichtung der Kristallachsen des Kristalls relativ zur Lichtausbreitungsrichtung ab.

Das optische Rohelement wird aus diesem optisch polarisationsaktiven Material durch Zusammenfügen mehrerer Substrate, von denen mindestens ein Substrat optisch polarisationsaktiv ist, hergestellt. Bei der Unterteilung des optischen Rohelements entsprechend den späteren Einzelelementen werden auf dem Rohelement diejenigen Abschnitte vorgegeben und beispielsweise markiert, in denen später die Einzelelemente mit der jeweiligen bündelformenden und polarisierenden Wirkung angeordnet sind.

Soweit das optische Rohelement in eine Variante, die nicht zur erfindung gelöst, aus einem einzigen Substrat ausgeführt ist, wird dieses Substrat selektiv geätzt, wobei diejenigen Bereiche des optischen Rohelements, die geätzt wurden und dadurch eine andere Schichtdicke aufweisen als die anderen Bereiche, sich in ihrer polarisationsoptischen Wirkung von den anderen Bereichen unterscheiden. Neben dem so hergestellten optischen Rohelement kann das diffraktive optische Elemente zur Erzeugung oder zur Unterstützung einer bündelformenden Wirkung der Einzelelemente zusätzlich eine vom optischen Rohelement beabstandet angeordnete diffraktive optische Komponente aufweisen. Das optische Rohelement kann dann eine rein polarisierende Wirkung am Ort der Einzelelemente haben und muss keine bündelformende Wirkung aufweisen. Alternativ ist es möglich, die bündelformende Wirkung der Einzelelemente auf das optische Rohelement einerseits und die weitere diffraktive optische Komponente andererseits zu verteilen. Der Abstand des diffraktiven optischen Elements vom optischen Rohelement kann in diesem Fall kleiner als 20 mm und vorzugsweise kleiner als 5 mm sein. Die diffraktive optische Komponente kann auch direkt am optischen Rohelement anliegend angeordnet sein.

Mit dem erfindungsgemäßen Verfahren können fertigungsbedingte Abtragungsungenauigkeiten vermieden werden, da die Schichtstärke des Profilformungssubstrats am Ort vorgegebener Einzelelemente vollständig, also bis zum Bündelformungssubstrat, abgetragen wird. Hierdurch kommt das polierte Bündelformungssubstrat wieder zum Vorschein, dessen Ebenheit der geforderten Tiefentoleranz entspricht. Auf diese Weise können diffraktive optische Elemente mit mehreren Typen von Einzelelementen mit exakt definierter bündelformender und polarisierender Wirkung hergestellt werden. Eine Rauhigkeit bzw. Unebenheit geätzter Oberflächen stört bei diesem Verfahren nicht. Es ist beispielsweise eine Tiefentoleranz von +/- 1,5 µm auf den geätzten Oberflächen realisierbar.

Ein Abtragen mit Abtragungsschritten nach Anspruch 2 führt zu Einzelelementen mit gut definierten Kanten, deren Abweichung von der Senkrechten gering ist. Unerwünschtes Streulicht ist an derartigen Kanten minimiert.

Ein Aufsprengen nach Anspruch 3 vermeidet eine Haftvermittlungsschicht zwischen dem Bündelformungs- und dem Polarisationsformungssubstrat. Nach dem vollständigen, selektiven Abtragen des Polarisationsformungssubstrats braucht daher keine Zwischensicht abgetragen zu werden, um die polierte Seite des Bündelformungssubstrats nutzen zu können.

Ein Abtragen nach Anspruch 4 ermöglicht ein exaktes Ausformen der durch Freilegen erzeugten Einzelelemente, insbesondere mit senkrechten Kanten zwischen den freigelegten Einzelelementen und den der freigelegten Einzelelemente benachbarten Einzelelementen.

Ätzstrukturen nach Anspruch 5 lassen sich verglichen mit vollflächigen Ätzstrukturen mit relativ geringem Aufwand herstellen.

Ein Erhitzen nach Anspruch 6 lässt sich sehr ortsselektiv realisieren.

Ein vorgeschalteter Polierschritt vor dem Abtragen nach Anspruch 7 ermöglicht eine exakte Voreinstellung der polarisierenden Wirkung der nicht abgetragenen Einzelelemente.

Durch ein zusätzliches Abtragen nach Anspruch 8 lassen sich, wenn auch mit einer Ätztiefenungenauigkeit behaftete, Einzelelemente mit weiteren Kombinationen aus bündelformender und polarisierender Wirkung herstellen. Das auf diese Weise hergestellte diffraktive optische Element kann dann beispielsweise drei verschiedene Typen von Einzelelementen mit jeweils vorgegebener bündelformender und polarisierender Wirkung aufweisen.

Durch einen Fügeschritt nach Anspruch 9 lassen sich diffraktive optische Elemente mit Einzelelementen mit weiteren Kombinationen aus bündelformenden und optischen Wirkungen erzeugen, ohne hierbei das Problem der Ätztiefenungenauigkeit in Kauf nehmen zu müssen. Das Zusammenfügen der einzelnen Substratschichten eines derartigen Mehrschicht-Substrates kann durch Aufsprengen erfolgen.

Ein diffraktives optisches Element nach Anspruch 10 hat die Vorteile, die vorstehend im Zusammenhang mit dem Herstellungsverfahren genannt wurden.

Eine weitere Aufgabe der Erfindung ist es, eine Beleuchtungsoptik mit dem erfindungsgemäß hergestellten diffraktiven optischen Element sowie eine Mikrolithografie-Projektionsbelichtungsanlage mit einer derartigen Beleuchtungsoptik anzugeben.

Die Aufgabe ist erfindungsgemäß gelöst durch eine Beleuchtungsoptik nach Anspruch 11 und durch eine Mikrolithografie-Projektionsbelichtungsanlage nach Anspruch 12. Deren Vorteile entsprechen denjenigen, die vorstehend im Zusammenhang mit dem diffraktiven optischen Element und seinem Herstellungsverfahren angegeben wurden.

Eine weitere Aufgabe der Erfindung ist es schließlich, ein Herstellungsverfahren für ein mikroelektronisches Bauelement anzugeben, welches die Vorteile des erfindungsgemäß hergestellten diffraktiven optischen Elements nutzt.

Diese Aufgabe ist erfindungsgemäß gelöst durch ein Herstellungsverfahren nach Anspruch 13.

Ein Ausführungsbeispiel der Erfindung wird nachfolgend anhand der Zeichnung näher erläutert. In dieser zeigen:
- Fig. 1: eine schematische Übersicht einer Mikrolithografie-Projektionsbelichtungsanlage mit einer ein nach dem erfindungsgemäßen Verfahren hergestelltes diffraktives optisches Element enthaltenden Beleuchtungsoptik;
- Fig.2: eine Aufsicht auf ein erfindungsgemäß hergestelltes diffraktives optisches Element;
- Fig. 3: einen Schnitt gemäß Linie III-III in Fig. 2;
- Fig. 4: eine Seitenansicht eines optischen Rohelements während des Verfahrens zur Herstellung des diffraktiven optischen Elements;
- Fig. 5: eine Aufsicht auf das optische Rohelement nach Fig. 4;
- Fig. 6: eine Aufsicht auf das Rohelement nach den Fig. 4 und 5 während des weiteren Herstellungsverfahrens; und
- Fig. 7: einen Schnitt gemäß Linie VII-VII in Fig. 6.

Eine Mikrolithografie-Projektionsbelichtungsanlage 1 hat ein Beleuchtungssystem mit einer Beleuchtungsoptik 2 zur Ausleuchtung eines definierten Beleuchtungsfeldes 3 am Ort eines Retikels 4, welches die für die Produktion mikrostrukturierter bzw. mikroelektronischer Bauelemente zu projizierende Vorlage darstellt.

Als Lichtquelle 5 für das Beleuchtungssystem dient ein Laser im tiefen Ultraviolett (DUV). Hierbei kann es sich um einen ArF-Excimer-Laser handeln. Auch andere DUV-Quellen sind möglich.

Ein Strahlaufweiter 6, z. B. eine aus der DE-A 41 24 311 bekannte Spiegelanordnung, dient zur Kohärenzreduktion und zur Erzeugung eines auf geweiteten, kollimierten, rechteckigen Querschnitts eines Beleuchtungsstrahls 7.

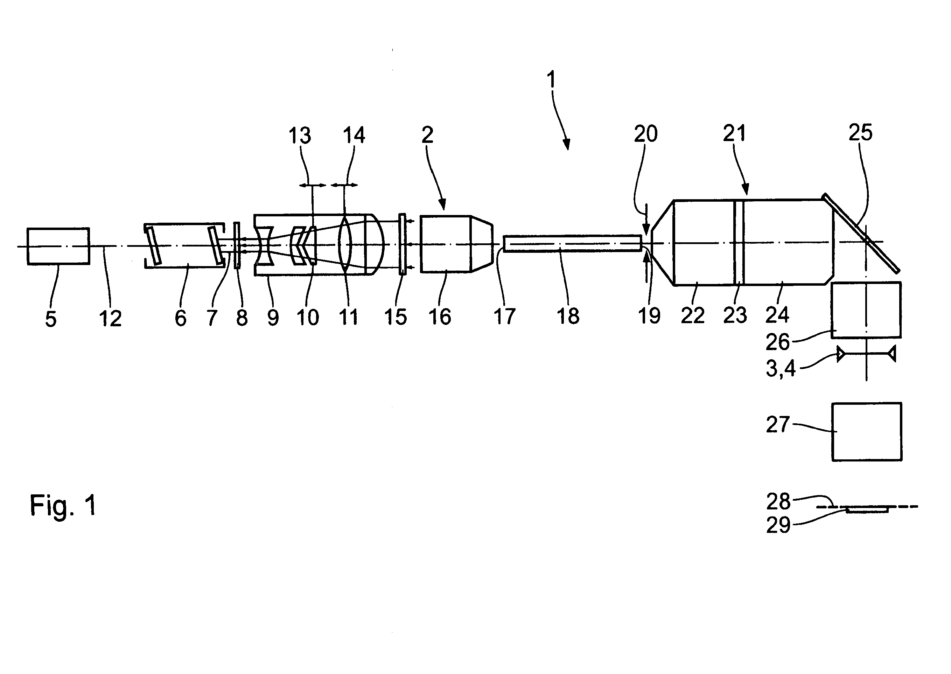

Ein erstes diffraktives optisches Rasterelement (DOE) 8, welches mit dem erfindungsgemäßen Verfahren hergestellt werden kann und nachfolgend noch näher beschrieben wird, ist in einer Objektebene eines Objektivs 9 angeordnet. Das Objektiv 9 ist als Kondensor gestaltet und umfasst ein Axicon-Paar 10 und eine Linse 11 mit positiver Brennweite. Der Abstand der Axicon-Elemente des Axicon-Paars 10 zueinander sowie die Position der Linse 11 sind längs einer optischen Achse 12 der Beleuchtungsoptik 2 verstellbar, wie in der Fig. 1 durch Doppelpfeile 13, 14 angedeutet. Das Objektiv 9 stellt daher ein Zoom-Objektiv dar.

In einer Austritts-Pupillenebene des Objektivs 9 ist ein zweites diffraktives optisches Rasterelement (DOE) 15 angeordnet, welches ebenfalls nach dem erfindungsgemäßen Verfahren hergestellt sein kann und nachfolgend noch beschrieben wird.

Eine dem zweiten DOE 15 nachgeordnete Einkoppeloptik 16 überträgt das Beleuchtungslicht auf eine Eintrittsfläche 17 eines Glasstabs 18, der durch mehrfache innere Reflexion das Beleuchtungslicht mischt und homogenisiert. Unmittelbar an einer Austrittsfläche 19 des Glasstabs 18 liegt eine Zwischenfeldebene, in der ein Retikel-Masking-System (REMA), eine verstellbare Feldblende, angeordnet ist.

Ein nachfolgendes Objektiv 21 mit Linsengruppen 22. 23, 24, einem Umlenkspiegel 25 und einer weiteren Linsengruppe 26 bildet die Zwischenfeldebene des REMA 20 auf das Retikel 4 ab. Das Objektiv 21 hat eine interne Pupillenebene.

Ein Projektionsobjektiv 27 bildet die Ebene, in der die zu projizierende Oberfläche des Retikels 4 liegt, in eine Bildebene 28 ab, in der eine zu belichtende Oberfläche eines Wafers 29 angeordnet ist, die wiederum mit einer für das Beleuchtungslicht empfindlichen Beschichtung versehen ist.

Die verschiedenen Objektive der Projektionsbelichtungsanlage 1 sind in der Fig. 1 schematisch als refraktive Objektive angedeutet. Genauso kann es sich auch um katadioptrische oder um reflektive Objektive handeln.

Mit dem ersten DOE 8 kann am Ort des zweiten DOE 15 eine definierte Intensitätsverteilung eingestellt werden, wodurch ein vorgegebenes sogenanntes Beleuchtungssetting erzeugt wird, z. B. ein Dipol-, Quadrupol-, annulares oder konventionelles Setting. Das zweite DOE 15 führt eine Divergenzverteilung mit einem Aspektverhältnis ein, die dem Aspektverhältnis der Eintrittsfläche 17 des Glasstabs 18 entspricht, sodass die Feldverteilung an der Eintrittsfläche 17 genau deren Form und Größe entspricht.

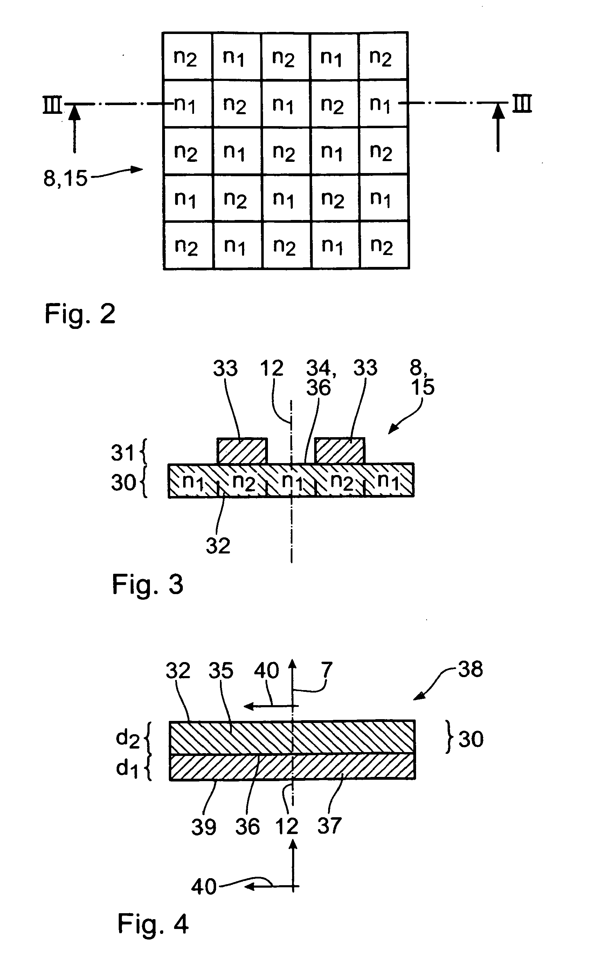

Fig. 2 und 3 zeigen ein Beispiel für die DOEs 8, 15.

Die DOEs 8, 15 sind zweischichtig aufgebaut und haben eine in der Fig. 3 unten dargestellte Bündelformungsschicht 30 und eine in der Fig. 3 oben dargestellte Polarisationsformungsschicht 31.

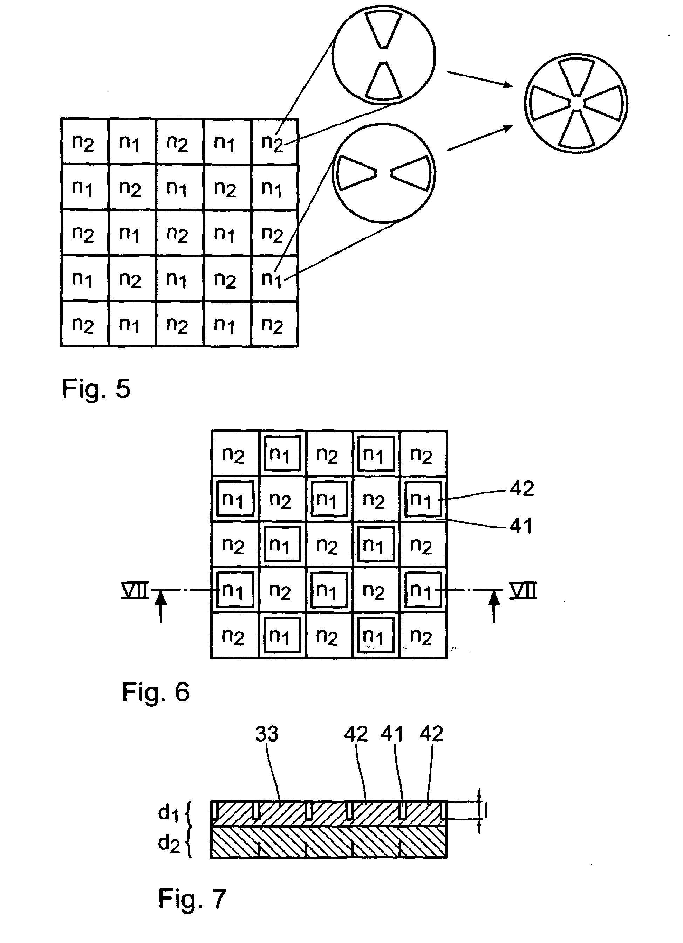

Die Bündelformungsschicht 30 hat an ihrer freien Oberfläche 32 eine Computer-Generated Hologramm (CGH-)Struktur mit Einzel-Rasterelementen n₁ und n₂. Wie in der Fig. 5 veranschaulicht, erzeugen die Rasterelemente n₁ eine Dipol-Beleuchtung mit in der Fig. 5 horizontaler Dipol-Achse (x-Dipol). Die Rasterelemente n₂ erzeugen eine Dipol-Beleuchtung mit in der Fig. 5 vertikaler Dipolachse (y-Dipol). Die Rasterelemente n₁ und n₂ wechseln in den DOEs 8, 15 nach Art der schwarzen und weißen Felder eines Schachbretts einander ab. In der Superposition erzeugt das DOE 8, 15 daher eine Quadrupol-Beleuchtung, wie in der Fig. 5 ganz rechts dargestellt. Dies kann beispielsweise zur Erzeugung eines Quadrupol-Beleuchtungssettings genutzt werden.

Die Polarisationsformungsschicht 31 weist einzelne Polarisations-Rasterelemente 33 auf, die genau auf den Bündelformungs-Rasterelementen n₂ angeordnet sind und sowohl in ihrer Position als auch in ihrer Apertur mit den Bündelformungs-Rasterelementen n₂ übereinstimmen. Die Polarisations-Rasterelemente 33 grenzen aneinander über Eck nach Art z. B. der schwarzen Felder eines Schachbretts aneinander an. Dazwischen, entsprechend also dem Ort der weißen Felder des Schachbretts, liegen Freiräume, sodass dort eine der Oberfläche 32 gegenüberliegende Gegenfläche 34 der Bündelformungsschicht 30 frei zugänglich ist.

Die Polarisations-Rasterelemente 33 sind aus einem optisch polarisationsaktiven, insbesondere einem optisch doppelbrechenden Material und/oder einem optisch aktiven Material und beeinflussen die Polarisation, insbesondere die Polarisationsrichtung des Beleuchtungslichts, welches das DOE 8, 15 passiert. Eine optische Achse des Materials der Polarisations-Rasterelemente 33 kann senkrecht zur optischen Achse 12 der Beleuchtungsoptik 2, parallel zur optischen Achse 12 der Beleuchtungsoptik 2 oder auch um einen vorgegebenen Winkel zu dieser angeordnet sein.

Die Bündelformungsschicht 30 ist aus einem nicht doppelbrechenden, also optisch homogenen Material.

Das DOE 8, 15 nach den Fig. 2 oder 3 wird folgendermaßen hergestellt:

Zunächst wird ein in der Fig. 4 oben dargestelltes Bündelformungssubstrat 35 auf einer Fügeseite 36 poliert, sodass dort die optisch polierte Gegenfläche 34 entsteht. Anschließend wird das Bündelformungssubstrat 35 mit einem optisch doppelbrechenden Polarisationsformungssubstrat 37 zu einem optischen Rohelement 38 zusammengefügt. Das Zusammenfügen der beiden Substrate 35, 37 kann durch Aufsprengen erfolgen. Auf der Oberfläche 32 des Bündelformungssubstrats 35, die in der Fig. 4 oben dargestellt ist, werden dann bündelformende CGH-Strukturen durch computergenerierte Holographie, also die Bündelformungs-Rasterelemente n₁, n₂ aufgebracht. Bei der Aufbringung der CGH-Strukturen wird das Bündelformungssubstrat 35 entsprechend den späteren Einzel- bzw. Rasterelementen unterteilt. Die Situation nach dem Aufbringen der CGH-Strukturen zeigen die Fig. 4 und 5. Das Bündelformungssubstrat 35 hat schon seine endgültige Form, sodass die Bündelformungsschicht 30 mit der Schichtstärke d₂ schon fertiggestellt ist. Die CGH-Strukturen können beispielsweise Mehrstufen-Strukturen sein.

Nun wird noch aus dem Polarisationsformungssubstrat 37 die Polarisationsformungsschicht 31 hergestellt. Vorbereitend wird hierzu eine der Oberfläche 32 gegenüberliegende freie Oberfläche 39 des Polarisationsformungssubstrats 37 poliert, bis dieses eine zur Polarisationsbeeinflussung gewünschte Schichtdicke d₁ aufweist. Beispielsweise kann gewünscht sein, dass ein senkrecht zur optischen Achse 12 der Beleuchtungsoptik 2 polarisierter Beleuchtungsstrahl 7 seine Polarisationsrichtung beibehält. Diese Situation ist in der Fig. 4 dargestellt, wobei die senkrechte Polarisation durch Pfeile 40 angedeutet ist.

Nach der Einstellung der Schichtstärke d₁ wird das Polarisationsformungssubstrat 37 am Ort der Rasterelemente n₁ der Bündelformungsschicht bis zur Gegenfläche 34 abgetragen. Dies geschieht durch Aufbringen von Ätzstrukturen 41 in Form von rechteckig um die Rasterelemente n₁ im Polarisationsformungssubstrat 37 umlaufenden Ätzstrukturen in Form von Ätznuten. Die Ätznuten werden von einem Laser aufgebracht. Nach dem Ätzen, das bis zu einer Tiefe 1 < d₁ erfolgt (vgl. Fig. 7), bleiben im Polarisationsformungssubstrat 37 rechteckige Ätz-Überstände 42 am Ort der Rasterelemente n₁ stehen.

Die Ätz-Überstände 42 werden anschließend durch gezielte Laserbestrahlung so erhitzt, dass sie sich von der Gegenfläche 34 vollständig lösen, sodass alleine die jeweils zwischen den Ätz-Überständen 42 liegenden Polarisations-Rasterelemente 33 in der Polarisationsformungsschicht 31 übrig bleiben.

Das so hergestellte DOE weist zwei verschiedene Typen von Einzelelementen auf, die nach Art der weißen und schwarzen Felder eines Schachbretts angeordnet sind. Bei dem einen Typ von Einzelelementen handelt es sich um die Bündelformungs-Rasterelemente n₁. Der andere Typ von Einzelelementen sind Einzelelemente mit der kombinierten Wirkung der Polarisations-Rasterelemente 33 und der Bündelformungs-Rasterelemente n₂.

Beim DOE 8, 15 werden also x-Dipolstrukturen mit definierter Polarisation und y-Dipolstrukturen mit hiervon unterschiedlicher Polarisation erzeugt.

Alternative, durch dieses Verfahren hergestellte DOEs können mehr als zwei Typen von Einzelelementen mit jeweils voneinander unterschiedlicher bündelformender und/oder polarisierender Wirkung aufweisen.

Bei einer nicht dargestellten Variante des DOE 8, 15 liegen Polarisations-Rasterelemente mit verschiedener Polarisationswirkung vor. Neben den Polarisations-Rasterelementen 33 werden an vorgegebenen Orten in der Polarisations-Formungsschicht 31 weitere Polarisations-Rasterelemente dadurch erzeugt, dass das Polarisations-Formungssubstrat 37 an diesen weiteren Polarisations-Rasterelementen nicht vollständig bis zur Gegenfläche 34, sondern bis zu einer vorgegebenen Rest-Schichtstärke der Polarisations-Formungsschicht 31 abgetragen wird. Diese Rest-Schichtstärke kann z. B. d₁-1 (vgl. Fig. 7) betragen. Aufgrund der geringeren Schichtstärke der weiteren Polarisations-Rasterelemente haben diese eine andere polarisierende Wirkung als die Polarisations-Rasterelemente 33.

Das optische Rohelement 38 kann zur Herstellung eines weiteren alternativen DOE mit einem weiteren optisch doppelbrechenden Polarisations-Formungssubstrat zu einem optischen Mehrschicht-Rohelement, also z. B. zu einem Dreischicht-Rohelement, zusammengefügt werden.

Das Herstellungsverfahren für ein DOE, welches vorstehend beschrieben wurde, ist nicht auf das Schachbrett-Beispiel der Anordnung der Rasterelemente n₁, n₂ beschränkt. Das DOE kann alternativ eine zeilen- oder spaltenweise Streifenanordnung aus ersten Streifenelementen, die den Rasterelementen n₁ entsprechen, und aus zweiten Steifenelementen, die den Rasterelementen n₂ entsprechen, aufweisen. Die ersten und zweiten Streifenelemente haben entsprechend wie die Rasterelemente n₁, n₂ unterschiedliche Auswirkungen auf den sie durchtretenden Beleuchtungsstrahl. Die Streifenelemente können sich in ihrer Schichtstärke d sowie in ihrer Streifenbreite unterscheiden.

Eine weitere, nicht Teil der Erfindung bildende Variante eines diffraktiven optischen Elements, dessen Auf sicht derjenigen der Fig. 2 und dessen prinzipieller Querschnitt demjenigen nach Fig. 3 entspricht, kann aus einem einstückigen optischen Rohelement hergestellt werden. Das zugehörige Herstellungsverfahren wird nachfolgend auf Basis der Fig. 2 und 3 beschrieben. Zunächst liegt ein Substrat mit einer Schichtstärke d₁ + d₂ vor. Dieses Substrat ist einstückig aus einem optisch polarisationsaktiven Material. Am Ort mit Hilfe einer entsprechenden Unterteilung, beispielsweise mit Hilfe einer Markierung, vorgegebener Einzelelemente n₁, n₂ wird dann das optische Rohelement bis zu einer vorgegebenen Tiefe d₁ abgetragen. Hierbei können, eine entsprechende Anordnung der herzustellenden Einzelelemente vorausgesetzt, zunächst parallele Stege mit einem Verlauf senkrecht zur Zeichenebene der Fig. 3 und einem Querschnitt entsprechend dem der Rasterelemente 33 in der Fig. 3 hergestellt werden. Der Querschnitt des so hergestellten einstückigen Substrats unterscheidet sich von dem nach Fig. 3 dann lediglich dadurch, dass keine Trennung zwischen zwei Substraten vorliegt.

Nach dem ersten Abtragungsschritt, bei dem die Stege hergestellt wurden, werden in einem zweiten Abtragungsschritt die Stege dann abschnittsweise zur Ausbildung der Einzelelemente n₁, n₂ längs der Stege abgetragen. Die Stege werden also im zweiten Abtragungsschritt längs vorgegebener Abschnitte unterbrochen.

Auf der den so durch Abtragen hergestellten Einzelelementen gegenüberliegenden Seite des optischen Rohelements können dann noch bündelformende CGH-Strukturen aufgebracht werden, wie vorstehend bereits erläutert wurde.

Zusätzlich zur so aus dem optischen Rohelement hergestellten einstückigen Komponente kann eine weitere diffraktive optische Komponente vorgesehen sein, wobei sich die beiden Komponenten dann zum DOE ergänzen. Die beiden Komponenten werden in geringem Abstand zueinander im Strahlengang des Beleuchtungssystems angeordnet.

## Patentansprüche

1. Verfahren zur Herstellung eines diffraktiven optischen Elements (8; 15), welches in eine Mehrzahl von nebeneinander angeordneten Einzelelementen (n₁; n₂, 33) unterteilt ist, wobei jedes der Einzelelemente (n₁; n₂, 33) eine bestimmte bündelformende und polarisierende Wirkung aus einer Mehrzahl vorgegebener bündelformender und polarisierender Wirkungen hat, mit folgenden Verfahrensschritten:
- Bereitstellen mindestens eines Substrates (35, 37) aus einem optisch polarisationsaktiven Material,
- Herstellen eines optischen Rohelements (38) aus dem mindestens einen bereitgestellten Substrat (35, 37),
- Unterteilung des Rohelements (38) entsprechend den späteren Einzelelementen (n₁; n₂),
- Abtragen des optischen Rohelements (38) am Ort der vorgegebenen Einzelelemente (n₁; n₂) bis zu einer vorgegebenen Tiefe (d₁), wobei das optische Rohelement (38) durch Zusammenfügen mehrerer Substrate (35, 37) hergestellt wird, von denen mindestens ein Substrat (37) optisch polarisationsaktiv ist,
- wobei das optische Rohelement (38) ein Polarisationsformungssubstrat (37) aus dem optisch polarisationsaktiven Material und ein Bündelformungssubstrat (35) aufweist, wobei bei der Herstellung des diffraktiven optischen Elements (8; 15) das Bündelformungssubstrat (35) auf einer Fügeseite (36) optisch poliert wird, das Bündelformungssubstrat (35) mit dem Polarisationsformungssubstrat (37) zum optischen Rohelement (38) zu dessen Herstellung zusammengefügt wird, bündelformende Strukturen in das Bündelformungssubstrat (35) aufgebracht werden, wobei dieses Aufbringen entsprechend der Unterteilung in die Einzelelemente (n₁; n₂) erfolgt, und wobei die Schichtstärke (d₁) des Polarisationsformungssubstrats (37) am Ort vorgegebener Einzelelemente (n₁; n₂) bis zur polierten (34) Fügeseite (36) des Bündelformungssubstrats (35) abgetragen wird.

2. Verfahren nach Anspruch 1, **dadurch gekennzeichnet, dass** beim Abtragen in einem ersten Abtragungsschritt zunächst Stege im optischen Rohelement (38) erzeugt werden, und diese Stege in einem zweiten Abtragungsschritt dann abschnittsweise zur Ausbildung der Einzelelemente (n₁; n₂) abgetragen werden.

3. Verfahren nach einem der Ansprüche 1 bis 2, **dadurch gekennzeichnet, dass** das Zusammenfügen des Bündelformungssubstrats (35) mit dem Polarisationsformungssubstrat (37) durch Aufsprengen erfolgt.

4. Verfahren nach einem der Ansprüche 1 bis 3, **dadurch gekennzeichnet, dass** das Abtragen erfolgt durch
- Aufbringen von Ätzstrukturen (41) in das Polarisationsformungssubstrat (37),
- Erhitzen von Ätz-Überständen (42) zwischen den Ätzstrukturen (41), bis das Polarisationsformungssubstrat (37) sich an den abzutragenden Orten vom Bündelformungssubstrat (35) löst, wodurch die polierte (34) Fügeseite (36) des Bündelformungssubstrats (35) am Ort der vorgegebenen Einzelelemente (n₁) freigelegt wird.

5. Verfahren nach Anspruch 4, **dadurch gekennzeichnet, dass** die Ätzstrukturen (41) längs des Umfangs der aus dem Polarisationsformungssubstrat (37) abzutragenden Einzelelemente aufgebracht werden.

6. Verfahren nach Anspruch 4 oder 5, **dadurch gekennzeichnet, dass** das Erhitzen durch Laserbestrahlen der vorgegebenen Ätz-Überstände (42) erfolgt.

7. Verfahren nach einem der Ansprüche 1 bis 6, **gekennzeichnet durch** das Polieren mindestens einer Außenfläche (32, 39) des optischen Rohelements (38) bis zu einem gewünschten Polarisationseinfluss nach dem Zusammenfügen und vor dem Schichtstärken-Abtrag am Ort vorgegebener Einzelelemente (n₁).

8. Verfahren nach einem der Ansprüche 1 bis 7, **gekennzeichnet durch** das zusätzliche Abtragen der Schichtstärke des Polarisationsformungssubstrats (37) am Ort weiterer, vorgegebener Einzelelemente bis zu einer vorgegebenen Rest-Schichtstärke (d₁ - 1) des Polarisationsformungssubstrats (37).

9. Verfahren nach einem der Ansprüche 1 bis 8, **gekennzeichnet durch** das Zusammenfügen des optischen Rohelements (38) mit einem weiteren optisch doppelbrechenden Polarisationsformungssubstrat zu einem optischen Mehrschicht-Rohelement.

10. Diffraktives optisches Element (8, 15), hergestellt nach einem Verfahren nach einem der Ansprüche 1 bis 9.

11. Beleuchhmgsoptik (2) mit mindestens einem diffraktiven optischen Element (8, 15) nach Anspruch 10.

12. Mikrolithografie-Projektionsbelichtungsanlage (1) mit einer Beleuchtungsoptik (2) nach Anspruch 11.

13. Verfahren zum mikrolithografischen Herstellen eines mikroelektronischen Bauelements mit folgenden Verfahrensschritten:
- Beschichten eines Wafers zumindest abschnittsweise mit einer lichtempfindlichen Schicht,
- Projizieren einer Struktur auf einem bereitgestellten Retikel (4) mit der Mikrolithografie-Projektionsbelichtungsanlage (1) nach Anspruch 12 auf den Wafer,
- Bearbeiten des belichteten Wafers zur Ausbildung des mikroelektronischen Bauelements.

## Claims

1. Method of producing a diffractive optical element (8; 15), which is divided into multiple adjacently arranged individual elements (n₁; n₂, 33), each of the individual elements (n₁; n₂, 33) having one specified bundle-forming and polarising effect out of multiple specified bundle-forming and polarising effects, with the following method steps:
- provision of at least one substrate (35, 37) of an optically polarisation-active material,
- production of an optical raw element (38) from the at least one provided substrate (35, 37),
- subdivision of the raw element (38) corresponding to the later individual elements (n₁; n₂),
- removing material from the optical raw element (38) at the location of the specified individual elements (n₁; n₂) to a specified depth (d₁)
wherein the optical raw element (38) is produced by joining a plurality of substrates (35, 37) at least one of which being optically polarisation-active optically polarisation-active,
- wherein the optical raw element (38) has a polarisation formation substrate (37) of the optically polarisation-active material and a bundle formation substrate (35), in the production of the diffractive optical element (8; 15) the bundle formation substrate (35) being optically polished on one joining side (36), the bundle formation substrate (35) being joined to the polarisation formation substrate (37) to produce the optical raw element (38), bundle-forming structures being applied into the bundle formation substrate (35) and/or the polarisation formation substrate (37), this application taking place corresponding to the subdivision into the individual elements (n₁; n₂), and the layer thickness (d₁) of the polarisation formation substrate (37) at the location of specified individual elements (n₁; n₂) being removed as far as the polished (34) joining side (36) of the bundle formation substrate (35).

2. Method according to claim 1, **characterised in that** in the material removing, in a first removing step first fins are generated in the optical raw element (38), and in a second removing step these fins are then stripped in sections to form the individual elements (n₁; n₂).

3. Method according to one of claims 1 to 2, **characterised in that** the bundle formation substrate (35) is joined to the polarisation formation substrate (37) by matchingly thrusting both substrates jointly together.

4. Method according to one of claims 1 to 3, **characterised in that** the material removing is done by
- applying etch structures (41) into the polarisation formation substrate (37),
- heating etch projecting ends (42) between the etch structures (41) until the polarisation formation substrate (37) is detached from the bundle formation substrate (35) at the locations to be removed, so that the polished (34) joining side (36) of the bundle formation substrate (35) at the location of the specified individual elements (n₁) is uncovered.

5. Method according to claim 4, **characterised in that** the etch structures (41) are applied along the periphery of the individual elements to be removed from the polarisation formation substrate (37).

6. Method according to claim 4 or 5, **characterised in that** the heating is by laser irradiation of the specified etch projecting ends (42).

7. Method according to one of claims 1 to 6, **characterised by** the polishing of at least one outer surface (32, 39) of the optical raw element (38) to a desired polarisation influence after joining and before the removal of the layer thickness at the location of specified individual elements (n₁).

8. Method according to one of claims 1 to 7, **characterised by** the additional removal of the layer thickness of the polarisation formation substrate (37) at the location of further specified individual elements to a specified residual layer thickness (d₁ -1) of the polarisation formation substrate (37).

9. Method according to one of claims 1 to 8, **characterised by** the optical raw element (38) being joined to a further optically doubly refracting polarisation formation substrate to form an optical multilayer raw element.

10. Diffractive optical element (8, 15), produced according to a method according to one of claims 1 to 9.

11. Illumination optical system (2) with at least one diffractive optical element (8, 15) according to claim 10.

12. Microlithography projection exposure system (1) with an illumination optical system (2) according to claim 11.

13. Method of microlithographic production of a micro-electronic component, with the following method steps:
- coating a wafer at least in sections with a light-sensitive layer,
- projecting a structure on a provided reticle (4) with the microlithography projection exposure system (1) according to claim 12 onto the wafer,
- processing the exposed wafer to form the micro-electronic component.

## Revendications

1. Procédé de fabrication d'un élément optique diffractif (8 ; 15) qui est subdivisé en une multitude d'éléments individuels (n₁ ; n₂, 33) disposés les uns à côté des autres, chaque élément individuel (n₁ ; n₂, 33) possédant un rôle donné dans la formation des faisceaux et dans la polarisation parmi une multitude de rôles prédéterminés dans la formation des faisceaux et dans la polarisation, comprenant les étapes de procédé suivantes .
- préparation d'au moins un substrat (35, 37) constitué par un matériau optique actif en ce qui concerne la polarisation,
- fabrication d'un élément optique brut (38) à partir d'au moins un substrat (35, 37) préparé,
- subdivision de l'élément brut (38) en éléments individuels (n₁ ; n₂) ultérieurs,
- dégrossissage de l'élément optique brut (38) aux endroits prévus pour les éléments individuels (n₁ ; n₂) jusqu'à une profondeur (d₁) prédéterminée,
l'élément optique brut (38) étant fabriqué par l'assemblage de plusieurs substrats (35, 37) parmi lesquels au moins un substrat (37) est optiquement actif du point de vue de la polarisation,
- l'élément optique brut (38) présentant un substrat de formation de la polarisation (37) constitué du matériau optique actif du point de vue de la polarisation et un substrat de formation de faisceaux (35), le substrat de formation de faisceaux (35) étant poli optiquement sur une face de joint (36) lors de la fabrication de l'élément optique diffractif (8 ; 15), le substrat de formation de faisceaux (35) est assemblé avec le substrat de formation de la polarisation (37) en un élément optique brut (38) pour la fabrication de celui-ci, des structures formant des faisceaux sont rapportées sur le substrat de formation de faisceau (35), cet apport s'effectuant de manière correspondante à la subdivision en éléments individuels (n₁ ; n₂) , et l'épaisseur de la couche (d₁) du substrat de formation de la polarisation (37) étant dégrossie aux endroits prévus pour les éléments individuels (n₁ ; n₂) jusqu'au côté poli (34) du joint (36) du substrat de formation de faisceaux (35).

2. Procédé selon la revendication 1 **caractérisé en ce que**, lors du dégrossissage, tout d'abord des pontages sont réalisés dans l'élément optique brut (38) pendant une première étape de dégrossissage, et ces pontages sont ensuite enlevés progressivement pour la formation des éléments individuels (n₁ ; n₂) dans une seconde étape de dégrossissage.

3. Procédé selon l'une des revendications de 1 à 2 **caractérisé en ce que** l'assemblage du substrat de formation de faisceaux (35) avec le substrat de formation de polarisation (37) a lieu par compression.

4. Procédé selon l'une des revendications de 1 à 3 **caractérisé en ce que** le dégrossissage a lieu par
- l'apport de structures corrosives (41) dans le substrat de formation de la polarisation (37),
- le chauffage des résidus d'attaque (42) entre les structures corrosives (41) jusqu'à que le substrat de formation de polarisation (37) se détache du substrat de formation de faisceaux (35) aux endroits devant être dégrossis, ce par quoi le côté poli (34) du joint (36) du substrat de formation de faisceaux (35) est rendu libre à l'endroit prévu pour les éléments individuels (n₁).

5. Procédé selon la revendication 4 **caractérisé en ce que** les structures corrosives (41) sont rapportées le long du pourtour des éléments individuels à dégrossir constituant le substrat de formation de la polarisation (37).

6. Procédé selon les revendications 4 ou 5 **caractérisé en ce que** le chauffage des résidus d'attaque (42) prédéterminés est effectué par un rayonnement laser.

7. Procédé selon l'une des revendications de 1 à 6 **caractérisé par** le polissage d'au moins une surface externe (32, 39) de l'élément optique brut (38) jusqu'à un effet souhaité de polarisation après l'assemblage et avant le dégrossissage de l'épaisseur des couches à l'endroit des éléments individuels prédéterminés (n₁).

8. Procédé selon l'une des revendications de 1 à 7 **caractérisé par** le dégrossissage complémentaire de l'épaisseur de la couche du substrat de formation de polarisation (37) à l'endroit des autres éléments individuels prédéterminés jusqu'à une épaisseur de couche résiduelle prédéterminée (d₁ - 1) du substrat de formation de polarisation (37).

9. Procédé selon l'une des revendications de 1 à 8 **caractérisé par** l'assemblage de l'élément optique brut (38) avec un autre substrat de formation de polarisation doublement diffractif optiquement pour former un élément optique brut multicouche.

10. Elément optique diffractif (8, 15) fabriqué d'après un procédé selon l'une des revendications de 1 à 9.

11. Optique d'éclairage (2) comprenant au moins un élément optique diffractif (8, 15) selon la revendication 10.

12. Installation d'éclairage de projection par microlithographie (1) comprenant une optique d'éclairage (2) selon la revendication 11.

13. Procédé de fabrication microlithographique d'un élément de construction microélectronique comprenant les étapes de procédé suivantes :
- revêtement d'une plaquette au moins partiellement par une couche photosensible,
- projection sur la plaquette d'une structure sur un réticule (4) préparé comprenant une installation d'éclairage de projection par microlithographie (1) selon la revendication 12,
- transformation de la plaquette éclairée pour la formation de l'élément de construction microélectronique.
